# FASCICULE DE BREVET EUROPEEN

(11) **EP 0 817 337 B1**
(45) Date de publication et mention de la délivrance du brevet: **06.08.2003**
(21) Numéro de dépôt: 97401489.6
(22) Date de dépôt: 26.06.1997
(51) Int. Cl.: H01S 5/10

(54) **Procédé de fabrication d'un laser à émission par la surface**
Herstellungsverfahren für einen Oberflächenemittierenden Laser
Method of fabricating a surface emitting laser

(30) Priorité: 04.07.1996 FR 9608338
(43) Date de publication de la demande: 07.01.1998
(73) Titulaire: ALCATEL, 75008 Paris (FR)
(72) Inventeur: Plais, Antonina, 75019 Paris (FR); Salet, Paul, 92140 Clamart (FR); Jacquet, Joel, 91470 Limours (FR); Poingt, Francis, 91310 Lonpont-sur-Orge (FR); Derouin, Estelle, 91370 Verrieres le Buisson (FR)
(74) Mandataire: Fournier, Michel Robert Marie

(56) Documents cités:
- US-A- 5 416 044
- P.D FLOYD ET AL: "Comparison of optical losses in dielectric apertured vertical cavity lasers" IEEE PHOTONICS TECHNOLOGY LETTERS, vol. 8, no. 5, mai 1996, NEW YORK US, pages 590-592, XP002027623
- LI G S ET AL: "POLARISATION AND MODAL BEHAVIOUR OF LOW THRESHOLD OXIDE AND AIRGAP CONFINED VERTICAL CAVITY LASERS" ELECTRONICS LETTERS, vol. 31, no. 23, 9 novembre 1995, page 2014/2015 XP000546736
- SCOTT J W ET AL: "HIGH EFFICIENCY SUBMILLIAMP VERTICAL CAVITY LASERS WITH INTRACAVITY CONTACTS" IEEE PHOTONICS TECHNOLOGY LETTERS, vol. 6, no. 6, 1 juin 1994, pages 678-680, XP000457220
- YANG G M ET AL: "INFLUENCE OF MIRROR REFLECTIVITY ON LASER PERFORMANCE OF VERY-LOW- THRESHOLD VERTICAL-CAVITY SURFACE-EMITTING LASERS" IEEE PHOTONICS TECHNOLOGY LETTERS, vol. 7, no. 11, 1 novembre 1995, pages 1228-1230, XP000537942
- YANG G M ET AL: "ULTRALOW THRESHOLD CURRENT VERTICAL-CAVITY SURFACE-EMITTING LASERS OBTAINED WITH SELECTIVE OXIDATION" ELECTRONICS LETTERS, vol. 31, no. 11, 25 mai 1995, pages 886-888, XP000519105
- PATENT ABSTRACTS OF JAPAN vol. 95, no. 003 & JP 07 058408 A (FURUKAWA ELECTRIC CO LTD:THE), 3 mars 1995,

## Description

L'invention concerne les lasers semi-conducteurs appelés "lasers à émission par la surface" ou "VCSEL" (de l'anglais : "Vertical Cavity Surface Emitting Laser").

Ces lasers sont réalisés à partir d'un substrat composé d'un alliage semi-conducteur de type III-V tel que l'arséniure de gallium GaAs ou le phosphure d'indium InP.

Contrairement aux lasers semi-conducteurs classiques, l'émission de lumière s'effectue perpendiculairement à la surface de la couche active et dans la même direction que l'injection de courant électrique entretenant l'effet laser. Ainsi, dans le cas d'un substrat InP, le composant est essentiellement constitué d'une cavité résonnante délimitée par deux miroirs diélectriques ou semi-conducteurs opposés. La cavité résonnante est formée d'une couche d'InP dopée p, d'une couche active quaternaire GaInAsP non dopée et d'une couche d'InP dopée n. L'injection de courant s'effectue par l'intermédiaire de deux électrodes disposées de part et d'autres de la cavité résonnante. Lorsque le miroir est composé d'un matériau diélectrique, au moins une des électrodes est nécessairement placée à côté ou plus généralement autour de ce miroir.

Le bon rendement d'une telle structure est conditionné par un confinement suffisant de la couche active, aussi bien du point de vue optique qu'électrique. Pour cela, on peut choisir une structure où la couche active est enterrée dans un milieu possédant un plus faible indice de réfraction. Si la couche active est de plus enterrée dans un milieu dopé p à la frontière du milieu n, on obtiendra également un confinement électrique dû à la tension de seuil de la jonction p-n qui entoure la couche active.

Pour réaliser des lasers à forte puissance, à émission continue et fonctionnant à température ambiante, il est nécessaire de renforcer le confinement électrique afin d'améliorer le rendement et de diminuer l'échauffement du composant. Une solution à ce problème a été proposée dans l'article : " Continnous Wave GaInAsP/InP Surface Emitting Lasers with a Thermally Conductive MgO/Si Mirror ", Toshihiko BABA et al, Japanese Journal of Applied Physics, Vol.33 (1994), Part 1, N° 4A, avril 1994, pages 1905-1909.

Dans cet article, il est proposé de placer une jonction bloquante s'appuyant tout autour de la couche active enterrée. Cette solution permet bien d'améliorer le confinement électrique. Toutefois, le rendement n'est pas optimal. En effet, les mesures et les simulations sur une telle structure montre que la densité de courant à travers la couche active n'est pas uniforme. Plus précisément, la densité de courant est plus élevée (dans un rapport de l'ordre de 4) à la périphérie de la couche active qu'à son centre. Il en résulte que l'effet laser ne peut être obtenu que sur un mode annulaire car la densité de porteur au centre est inférieure à celle requise pour atteindre le seuil laser.

Une autre solution est décrite dans l'article " Ultralow threshold current vertical-cavity surface-emitting lasers obtained with sélective oxidation ", G.M. Yang et al, ELECTRONICS LETTERS, 25 Mai 1995, Vol. 31, No.11, pages 886 à 888. La structure proposée comporte une couche active non enterrée au-dessus de laquelle est placée une couche de confinement de courant. Cette couche est réalisée à partir d'une couche continue d'arséniure d'aluminium à laquelle on fait subir une oxydation latérale contrôlée de façon à laisser une ouverture de courant située en dessous du miroir supérieur. Cette solution assure une bonne planéité de la surface recevant le miroir mais exige un contrôle délicat de l'étape d'oxydation latérale. Il est par ailleurs nécessaire de déposer ensuite une couche de protection en nitrure de silicium pour arrêter l'oxydation de la couche d'arséniure d'aluminium.

L'article intitulé "High Efficiency Submilliamp Vertical Cavity Laser with Intracavity Contacts", IEEE Photonics Technology Letters, vol. 6, n° 6, juin 1994, pages 678-680, par J. W. Scott et al propose un procédé facile à mettre en oeuvre et applicable quelle que soit la composition du substrat, et qui évite les inconvénients des solutions précédentes.

Ce document décrit un procédé de fabrication d'un composant laser semi-conducteur à émission par la surface comprenant une cavité résonnante verticale formée sur un substrat constitué d'éléments III-V, ladite cavité contenant une couche d'injection de courant électrique munie d'une couche horizontale de confinement électrique disposée entre une couche active horizontale et un miroir délimitant la cavité. La formation de ladite couche d'injection de courant comprend les étapes suivantes :
- croissance au-dessus de la couche active d'une couche de sous-gravure transparente à la longueur d'onde de fonctionnement dudit composant,
- au moins une croissance sur ladite couche de sous-gravure d'une couche dopée consistant en éléments III-V,
- formation d'une mesa centrée par rapport à l'emplacement prévu pour ledit miroir et dont les parois latérales laissent apparaître ladite couche de sous-gravure et
- gravure latérale contrôlée de la couche de sous-gravure pour former ladite couche de confinement électrique.

Cette couche de confinement aura donc la forme d'un diaphragme ayant pour effet de concentrer les lignes de courant traversant la couche active sur une zone délimitée située à l'aplomb du miroir supérieur. Le procédé proposé présente d'abord l'avantage d'éviter tout problème de planéité des couches semi-conductrices situées entre le diaphragme et le miroir. En outre, le fait que la couche de confinement électrique soit réalisée par gravure latérale assure une parfaite isolation électrique tout autour du diaphragme.

L'invention a pour but de faciliter cette gravure latérale. Dans ce but, le procédé selon l'invention prévoit en outre que les parois latérales de la mesa sont formées de quatre plans verticaux orientés à environ 45 degrés des plans de clivage du substrat.

En effet, contrairement aux autres plans cristallographiques des alliages III-V, ceux qui sont orientés à 45 degrés des plans de clivage ont des propriétés de gravure identiques. Il en résulte que la gravure de la couche de sous-gravure est plus rapide et sa profondeur est la même dans les quatre directions, ce qui autorise une précision accrue quant à la forme et aux dimensions du diaphragme de confinement.

Selon un cas particulier de réalisation, les parois latérales de la mesa sont de mêmes dimensions, ce qui améliore la précision de gravure.
Dans les lasers à émission par la surface, on prévoit généralement une couche de contact située en dessous du miroir et servant d'interface avec l'électrode qui entoure ce miroir. Or, avec les types de substrat utilisés et compte tenu des propriétés optiques et électriques imposées, la composition de cette couche de contact a souvent des propriétés de gravure voisines de celles de la couche de sous-gravure,. Dans ce cas et pour éviter de devoir former la couche de contact après celle de confinement, on prévoira avantageusement que la formation de la mesa comprend :
- une première étape de gravure n'attaquant pas la couche de sous-gravure mais laissant apparaître ladite couche de contact,
- un dépôt sur ladite couche de contact d'une couche de protection ayant des propriétés de gravure différentes de celles de la couche de sous-gravure et
- au moins une seconde étape de gravure faisant apparaître la couche de sous-gravure.

Selon un aspect supplémentaire de l'invention, le dépôt de la couche de protection est précédé par une légère gravure latérale de la couche de contact. Cette disposition permet d'améliorer la fixation de la couche de protection sur les parois verticales de la mesa.

D'autres aspects et avantages de l'invention apparaîtront dans la suite de la description en référence aux figures.
- Les figures 1 à 9 illustrent les principales étapes de fabrication du laser selon l'invention ;
- la figure 10 est une vue en coupe du laser obtenu par le procédé selon l'invention
- la figure 11 est une vue de dessus montrant la forme de la couche de confinement.

Les étapes de fabrication qui vont être décrites sont données dans le cas particulier d'un substrat d'InP. Cependant, le procédé pourrait être appliqué à tout autre substrat composé d'éléments III-V tel que l'arséniure de gallium GaAs.

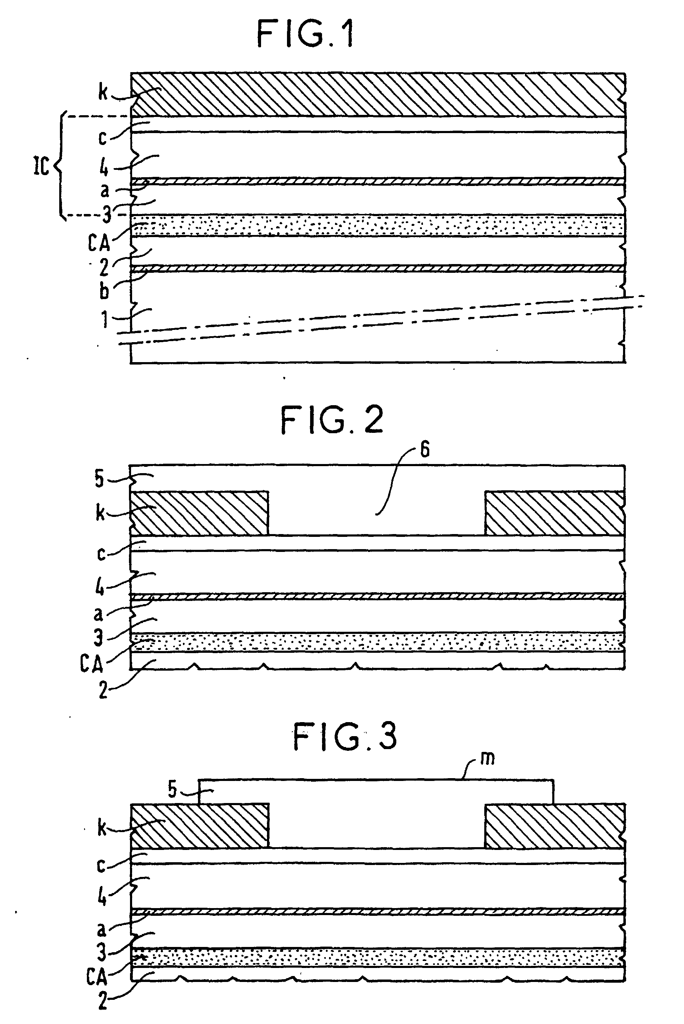

Comme représenté à la figure 1, on a déposé successivement sur un substrat 1 de phosphure d'indium dopé n une couche d'arrêt de gravure b, une couche 2 de même composition que le substrat, une couche active CA constituée d'un alliage quaternaire InGaAsP non dopé dont la composition définit la longueur d'onde caractéristique de la couche active, une couche 3 de phosphure d'indium dopé p, une couche de sous-gravure a, une couche 4 de phosphure d'indium dopée p, une couche de contact c composée d'un alliage ternaire InGaAs ou quaternaire InGaAsP fortement dopé p et enfin une couche métallique k composée par exemple d'un alliage d'or et de platine.

L'ensemble des couches 3,a,4,c constitue une couche d'injection de courant IC destinée à conduire le courant électrique issu de l'électrode supérieure entourant un miroir correspondant.

La couche de sous-gravure a est composée d'un alliage quaternaire InGaAsP dont la composition assure une longueur d'onde caractéristique inférieure à celle de la couche active CA. On choisira aussi une composition qui confère à cette couche des propriétés de gravure différentes de celle des couches voisines 3 et 4.

Comme le montre la figure 2, on effectue ensuite une gravure de la couche métallique k pour former une ouverture 6 définissant l'emplacement et la forme du miroir supérieur. On recouvre alors l'ensemble du composant d'une couche de protection 5. La couche 5 est par exemple constituée de silice SiO₂ ou de nitrure de silicium Si₃N₄.

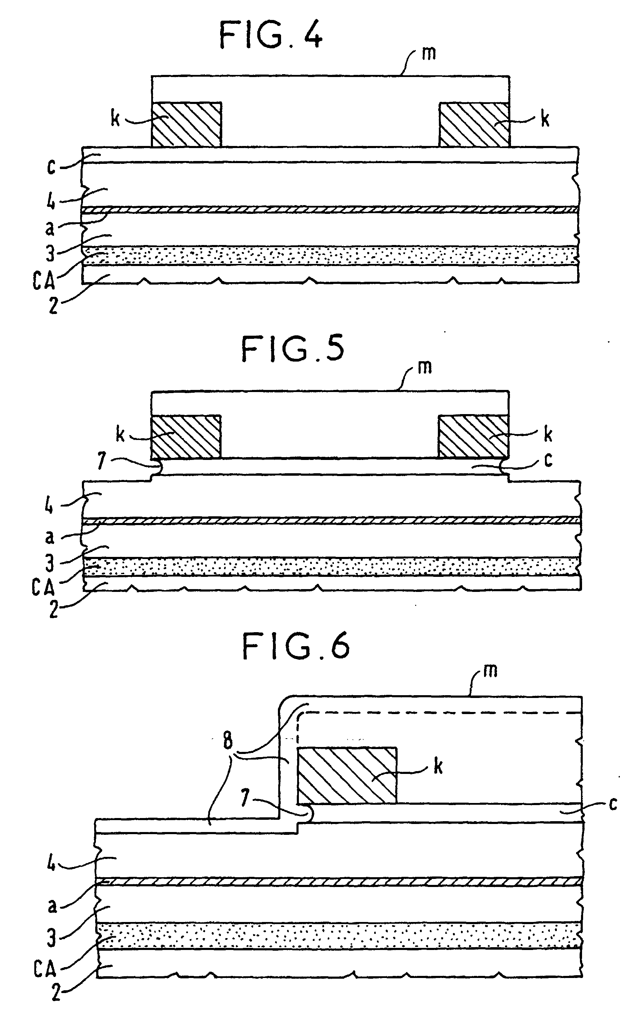

Conformément à la figure 3, on effectue une gravure, par exemple par ions réactifs (R I E), de la couche 5 à travers un masque de résine de façon à commencer la formation d'une mesa m. Un usinage ionique de la couche de métal k permet d'augmenter la hauteur de la mesa de façon à atteindre la couche de contact c. Le résultat obtenu apparaît sur la figure 4.

Après avoir retiré le masque de résine, on grave par R I E la couche de contact c et une partie de la couche 4 de façon à dégager latéralement la couche c. On effectue ensuite une légère sous-gravure de la couche de contact c par un procédé de gravure humide de façon à former une zone d'ancrage 7 (voir figure 5).

Conformément à la figure 6, on recouvre la plaquette d'une nouvelle couche de protection 8 réalisée par un dépôt isotrope d'un matériau de protection tel que de la silice. Ce dépôt peut être effectué par le procédé P E C V D (dépôt chimique en phase vapeur assisté par plasma).

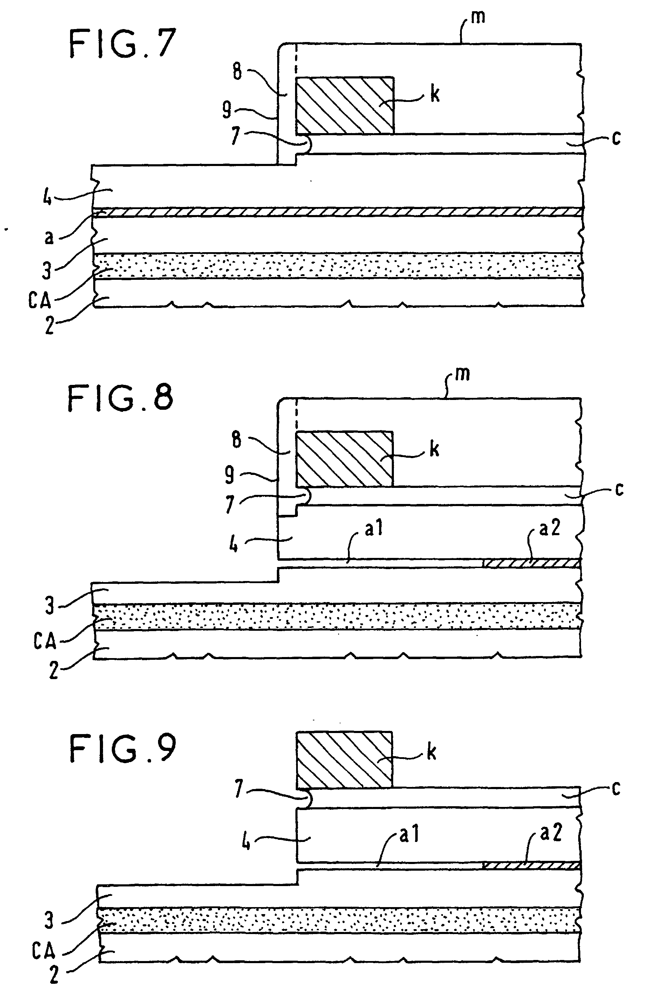

Puis, comme le montre la figure 7, on effectue une gravure anisotrope du matériau de protection de façon à éliminer la couche 8 des surfaces horizontales de la plaquette, sans toutefois la retirer des parois verticales 9 de la mesa m. On utilise par exemple une gravure par ions réactifs (R I E).

Une gravure R I E non sélective de la plaquette utilisant comme masque la silice recouvrant la mesa m permet alors de dégager les extrémités latérales de la couche de sous-gravure a à l'aplomb des parois verticales 9. La zone d'ancrage 7 a pour effet de renforcer l'adhérence de la couche de silice 8 recouvrant la paroi 9. On effectue ensuite une gravure sélective contrôlée de la couche de sous-gravure a de façon à former la couche de confinement de courant constituée d'un diaphragme a2 et de sa périphérie gravée a1, comme le montre la figure 8. Cette gravure contrôlée peut être réalisée par voie humide avec une solution 3H₂SO₄/H₂O₂/H₂O.

On élimine ensuite la silice subsistant sur la mesa (figure 9).

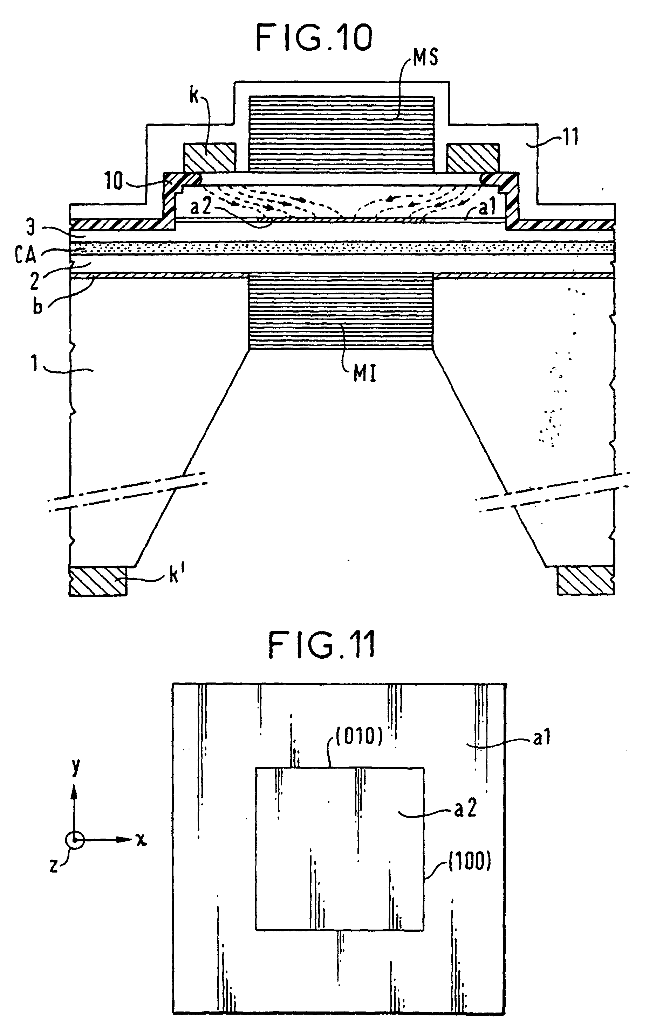

La forme finale du composant apparaît en coupe sur la figure 10. Elle est obtenue après un dépôt d'une couche de passivation 10 constituée par exemple de nitrure de silicium jouant le rôle d'isolant électrique. On dépose ensuite le miroir supérieur MS et on recouvre l'ensemble d'un revêtement conducteur 11 constitué par exemple d'une fine couche d'or (0,2µm) sur laquelle est déposé une barrière de diffusion de soudure composée par exemple d'un mélange de titane, de tungstène et d'or. Pour terminer la fabrication, on effectue ensuite une gravure de la partie inférieure du substrat jusqu'à la couche d'arrêt de gravure b, on forme le miroir inférieur MI et on place l'électrode inférieure k'.

Comme nous l'avons signalé précédemment, le choix des plans d'orientation des parois verticales de la mesa m ont une importance en ce qui concerne l'opération de gravure contrôlée de la couche de sous-gravure a. La figure 11 montre une vue de dessus de la couche de confinement en relation avec les plans cristallographiques du substrat. Conformément à une des conventions usuelles, la face horizontale du substrat est orientée selon le plan cristallographique (001). Ainsi, en orientant les parois verticales de la mesa selon les directions (100) et (010), on définit des plans orientés à 45 degrés des plans de clivage du substrat et ces plans présentent des propriétés de gravure identiques.

La couche de confinement représentée est constituée d'un diaphragme carré a2 entouré de la partie sous-gravée a1 également délimitée par un carré. Pour obtenir cette structure, il suffit que le masque de résine définissant la mesa (figure 3) soit également carré. Cela implique que les parois verticales de la mesa sont identiques.

Quelques données de dimensionnement sont enfin indiquées à titre d'illustration :
- épaisseur de la couche active CA : 0,7 µm
- épaisseur de la couche de sous-gravure a : 0,1 µm
- épaisseur de la couche d'arrêt de gravure b : 0,1 µm
- épaisseur de la couche de contact c : 0,2 µm
- épaisseur de la couche d'injection de courant CI : 3 µm
- épaisseur de la couche métallique k : 0,2 µm
- largeur de la mesa m : 12 à 20 µm
- largeur de la zone d'ouverture 6 : 6 à 10 µm
- longueur d'onde caractéristique de la couche active : 1,3 ou 1,5 µm
- longueur d'onde caractéristique de la couche de sous-gravure a : 1,18 µm

Bien entendu, l'invention n'est pas limitée au seul mode de réalisation qui vient d'être décrit. En particulier, le dépôt de la couche métallique k peut être effectué vers la fin du procédé en utilisant une technique dite de "lift" pour découvrir la zone du miroir en regard du diaphragme.

## Revendications

1. Procédé de fabrication d'un composant laser semi-conducteur à émission par la surface comprenant une cavité résonnante verticale formée sur un substrat constitué d'éléments III-V, ladite cavité contenant une couche d'injection de courant électrique (IC) munie d'une couche horizontale de confinement électrique (a1, a2) disposée entre une couche active horizontale (CA) et un miroir (MS) délimitant la cavité, la formation de ladite couche d'injection de courant (IC) comprenant les étapes suivantes :
- croissance au-dessus de la couche active (CA) d'une couche de sous-gravure (a) transparente à la longueur d'onde de fonctionnement dudit composant,
- au moins une croissance sur ladite couche de sous-gravure (a) d'une couche dopée consistant en éléments III-V,
- formation d'une mesa (m) centrée par rapport à l'emplacement prévu pour ledit miroir (MS) et dont les parois latérales (9) laissent apparaître ladite couche de sous-gravure (a) et
- gravure latérale contrôlée de la couche de sous-gravure (a) pour former ladite couche de confinement électrique (a1,a2),
ledit procédé étant **caractérisé en ce que** lesdites parois latérales (9) de la mesa (m) sont formées de quatre plans verticaux orientés à environ 45 degrés de plans de clivage du substrat.

2. Procédé selon la revendication 1, **caractérisé en ce que** lesdites parois latérales ont la même dimension.

3. Procédé selon l'une des revendications 1 ou 2, **caractérisé en ce que** ladite couche d'injection de courant (IC) comportant une couche de contact (c), ayant des propriétés de gravure voisines de celles de la couche de sous-gravure (a) et étant placée au-dessus de celle-ci, ladite formation de la mesa (m) comprend :
- une première étape de gravure n'attaquant pas la couche de sous-gravure (a) mais laissant apparaître ladite couche de contact (c),
- un dépôt sur ladite couche de contact (c) d'une couche de protection (8) ayant des propriétés de gravure différentes de celles de la couche de sous-gravure (a) et
- au moins une seconde étape de gravure faisant apparaître la couche de sous-gravure (a).

4. Procédé selon la revendication 3, **caractérisé en ce que** le dépôt de ladite couche de protection (8) est précédé par une légère gravure latérale (7) de la couche de contact (c).

5. Procédé selon l'une des revendications 3 ou 4, **caractérisé en ce que** le dépôt de ladite couche de protection (8) consiste en un dépôt isotrope d'une couche de matériaux de protection sur toute la surface du composant suivie par une gravure anisotrope pour éliminer ladite couche de matériaux de protection des faces horizontales du composant.

6. Procédé selon l'une des revendications 3 à 5, **caractérisé en ce que** ladite couche de protection (8) est constituée de silice.

7. Procédé selon l'une des revendications 1 à 6, **caractérisé en ce que** ledit substrat étant constitué de phosphure d'indium, ladite couche de sous-gravure (a) est constituée d'un composé quaternaire de phosphore, d'indium, de gallium et d'arsenic.

## Claims

1. A method of fabricating a surface emission semiconductor laser component including a vertical resonant cavity formed on a substrate consisting of III-V elements, said cavity containing an electrical current injection layer (IC) provided with a horizontal electrical confinement layer (a1, a2) disposed between a horizontal active layer (CA) and a mirror (MS) delimiting the cavity, the formation of said current injection layer (IC) including the following steps:
- growing on top of the active layer (CA) an undercutting layer (a) which is transparent at the operating wavelength of said component,
- growing on said undercutting layer (a) a doped layer consisting of III-V elements,
- forming a mesa (m) centred relative to the intended location of said mirror (MS) and whose lateral walls (9) expose said undercutting layer (a), and
- controlled lateral etching of the undercutting layer (a) to form said electrical confinement layer (a1, a2),
said method being **characterized in that** said lateral walls (9) of the mesa (m) are formed of four vertical planes oriented at approximately 45° to cleavage planes of the substrate.

2. A method according to claim 1, **characterized in that** said lateral walls have the same dimension.

3. A method according to either claim 1 or claim 2, **characterized in that** said current injection layer (IC) includes a contact layer (c) having etching properties similar to those of the undercutting layer (a) and is placed on top of the latter and said formation of the mesa (m) includes:
- a first etching step that does not etch the undercutting layer (a) but exposes said contact layer (c),
- depositing on said contact layer (c) a protection layer (8) having etching properties different from those of the undercutting layer (a), and
- a second etching step exposing the undercutting layer (a).

4. A method according to claim 3, **characterized in that** depositing said protection layer (8) is preceded by light lateral etching (7) of the contact layer (c).

5. A method according to claim 3 or claim 4, **characterized in that** depositing said protection layer (8) consists of isotropically depositing a layer of protection materials over the whole of the surface of the component followed by anisotropic etching to eliminate said layer of protection materials from the horizontal faces of the component.

6. A method according to any of claims 3 to 5, **characterized in that** said protection layer (8) is a layer of silica.

7. A method according to any of claims 1 to 6, **characterized in that** said substrate consists of indium phosphide and said undercutting layer (a) consists of a quaternary compound of phosphorus, indium, gallium and arsenic.

## Patentansprüche

1. Verfahren zur Herstellung einer Halbleiterlaser-Komponente mit Oberflächenemission, die einen vertikalen Resonanzraum aufweist, der in einem aus Elementen der Gruppe III-V gebildeten Substrat ausgebildet ist, wobei der Raum eine Schicht (IC) für die Einleitung von elektrischem Strom umfasst, die mit einer horizontalen Schicht (a1, a2) für den elektrischen Einschluss, die zwischen einer horizontalen aktiven Schicht (CA) und einem den Raum begrenzenden Spiegel (MS) angeordnet ist, versehen ist, wobei die Bildung der Stromeinleitungsschicht (IC) die folgenden Schritte umfasst:
- Aufwachsenlassen einer Unterätzschicht (a), die bei der Betriebswellenlänge der Komponente durchlässig ist, auf der aktiven Schicht (CA),
- wenigstens ein Aufwachsenlassen einer dotieriten Schicht, die aus Elementen der Gruppe III-V besteht, auf der Unterätzungsschicht (a),
- Bilden eines Mesa (m), das in Bezug auf den für den Spiegel (MS) vorgesehenen Ort zentriert ist und dessen Seitenwände (9) die Unterätzschicht (a) frei lassen, und
- gesteuertes seitliches Ätzen der Unterätzschicht (a), um die Schicht (a1, a2) für den elektrischen Einschluss zu bilden,
wobei das Verfahren **dadurch gekennzeichnet ist, dass** die Seitenwände (9) des Mesa (m) aus vier vertikalen Ebenen gebildet sind, die unter etwa 45 Grad zu den Spaltungsebenen des Substrats orientiert sind.

2. Verfahren nach Anspruch 1, **dadurch gekennzeichnet, dass** die Seitenwände gleiche Abmessungen haben.

3. Verfahren nach einem der Ansprüche 1 oder 2, **dadurch gekennzeichnet, dass** die Bildung des Mesa (m) dann, wenn die Stromeinleitungsschicht (IC) eine Kontaktschicht (c), die Ätzeigenschaften besitzt, die zu jenen der Unterätzschicht (a) ähnlich sind, aufweist und über jener angeordnet ist, umfasst:
- einen ersten Ätzschritt, der die Unterätzschicht (a) nicht angreift, jedoch die Kontaktschicht (c) freilegt,
- eine Ablagerung einer Schutzschicht (8), die andere Ätzeigenschaften als die Unterätzschicht (a) besitzt, auf der Kontaktschicht (c) und
- wenigstens einen zweiten Ätzschritt, der die Unterätzschicht (a) freilegt.

4. Verfahren nach Anspruch 3, **dadurch gekennzeichnet, dass** der Ablagerung der Schutzschicht (8) eine geringfügige seitliche Ätzung (7) der Kontaktschicht (c) vorhergeht.

5. Verfahren nach einem der Ansprüche 3 oder 4, **dadurch gekennzeichnet, dass** die Ablagerung der Schutzschicht (8) aus einer isotropen Ablagerung einer Schicht aus Schutzwerkstoffen auf der gesamten Oberfläche der Komponente, gefolgt von einer anisotropen Ätzung zur Beseitigung der Schicht aus Schutzwerkstoffen von den horizontalen Flächen der Komponente, besteht.

6. Verfahren nach einem der Ansprüche 3 bis 5, **dadurch gekennzeichnet, dass** die Schutzschicht (8) aus Siliciumdioxid gebildet ist.

7. Verfahren nach einem der Ansprüche 1 bis 6, **dadurch gekennzeichnet, dass** die Unterätzschicht (a) dann, wenn das Substrat aus Indiumphosphid gebildet ist, aus einer Quartärverbindung aus Phosphor, Indium, Gallium und Arsen gebildet ist.
